# EUROPÄISCHE PATENTANMELDUNG

(11) **EP 2 073 061 A2**
(43) Veröffentlichungstag der Anmeldung: **24.06.2009**
(21) Anmeldenummer: 08021427.3
(22) Anmeldetag: 10.12.2008
(51) Int. Cl.: G03F 7/20, G02B 27/10

(54) **Vorrichtung zur Ausleuchtung einer Fläche sowie Vorrichtung zur Beaufschlagung eines Arbeitsbereichs mit Licht**

(30) Priorität: 22.12.2007 DE 102007062564; 01.03.2008 DE 102008012047
(71) Anmelder: LIMO Patentverwaltung GmbH & Co. KG, 36419 Gerstengrund (DE)
(72) Erfinder: Hauschild, Dirk, 41539 Dormagen (DE); Jarczynski, Manfred, Dr., 45661 Recklinghausen (DE); Mitra, Thomas, Dr., 40237 Düsseldorf (DE)
(74) Vertreter: Basfeld, Rainer

(57) **Zusammenfassung**

Vorrichtung zur Ausleuchtung einer Fläche, insbesondere zur Ausleuchtung einer Maske (14), beispielsweise für eine lithografische Anwendung, umfassend mindestens eine Lichtquelle (1) zur Erzeugung von Licht (3), das für die Ausleuchtung verwendet werden kann, Optikmittel (2) zur Formung des von der mindestens einen Lichtquelle (1) erzeugten Lichts (3) sowie Separiermittel (4, 4'), die das für die Ausleuchtung zu verwendende Licht (3) derart in mehrere von einander separierte Teilstrahlen (5) aufteilen kann, dass diese die auszuleuchtende Fläche beabstandet zueinander ausleuchten können. Weiterhin betrifft die vorliegende Erfindung eine Vorrichtung zur Beaufschlagung eines Arbeitsbereichs mit Licht (3) mit einer derartigen Vorrichtung zur Ausleuchtung einer Fläche.

## Beschreibung

Die vorliegende Erfindung betrifft eine Vorrichtung zur Ausleuchtung einer Fläche gemäß dem Oberbegriff des Anspruchs 1. Weiterhin betrifft die vorliegende Erfindung eine Vorrichtung zur Beaufschlagung eines Arbeitsbereichs mit Licht mit einer derartigen Vorrichtung zur Ausleuchtung einer Fläche.

Derartige Vorrichtungen werden beispielsweise bei lithografischen Anwendungen zur Ausleuchtung einer Maske bezeihungsweise zusammen mit der Maske zur Beaufschlagung eines Arbeitsbereichs mit Licht genutzt. Das Licht einer in der Regel als Laser ausgebildeten Lichtquelle wird mit geeigneten Optikmitteln geformt, insbesondere homogenisiert und kollimiert und trifft gemäß dem Stand der Technik großflächig auf die Maske. Diese weist in der Regel eine Vielzahl kleiner Öffnungen oder transparenter Abschnitte auf, durch die ein häufig nur kleiner Teil des Lichts hindurch treten und für die lithografische Anwendung genutzt werden kann. Ein großer Teil des Lichts wird dabei von den opaken Bereichen zwischen den Öffnungen oder den transparenten Abschnitten der Maske absorbiert. Als nachteilig hierbei erweist es sich einerseits, dass Anwendungen wie die Laserablation mit derartigen Vorrichtungen wesentlich höhere Ausgangsleistungen der Lichtquelle erfordern als prinzipiell notwendig. Andererseits wird ein großer Teil der Lichtenergie von der Maske absorbiert, so dass diese unter Umständen aufwendig gekühlt werden muss.

Das der vorliegenden Erfindung zugrunde liegende Problem ist die Schaffung einer Vorrichtung zur Ausleuchtung einer Fläche der eingangs genannten Art und/oder einer Vorrichtung zur Beaufschlagung eines Arbeitsbereichs mit Licht der eingangs genannten Art, die niedrigere Leistungen der Lichtquelle erfordern.

Dies wird erfindungsgemäß hinsichtlich der Vorrichtung zur Ausleuchtung einer Fläche durch eine Vorrichtung der eingangs genannten Art mit den kennzeichnenden Merkmalen des Anspruchs 1 sowie hinsichtlich der Vorrichtung zur Beaufschlagung eines Arbeitsbereichs mit Licht durch eine Vorrichtung mit den Merkmalen des Anspruchs 15 erreicht. Die Unteransprüche betreffen bevorzugte Ausführungsformen der Erfindung.

Gemäß Anspruch 1 ist vorgesehen, dass die Vorrichtung Separiermittel umfasst, die das für die Ausleuchtung zu verwendende Licht derart in mehrere von einander separierte Teilstrahlen aufteilen können, dass diese die auszuleuchtende Fläche beabstandet zueinander ausleuchten können. Dadurch können gezielt die Öffnungen oder transparenten Abschnitt der Maske beleuchtet werden, wohingegen die zwischen diesen angeordneten opaken Bereiche der Maske weitgehend unbeleuchtet bleiben. Dadurch wird weniger Licht von der Maske absorbiert, so dass diese nicht gekühlt werden muss und die Intensität der Lichtquelle reduziert werden kann.

Es kann vorgesehen sein, dass die Separiermittel mindestens ein erstes Array von ersten Linsen umfassen, das das Licht zumindest hinsichtlich einer ersten Richtung in separate Teilstrahlen aufteilen kann, wobei die ersten Linsen vorzugsweise sämtlich die gleiche Brennweite aufweisen.

Alternativ besteht die Möglichkeit, dass zumindest eine der ersten Linsen eine von den Brennweiten der anderen ersten Linsen unterschiedliche Brennweite aufweist. Dadurch kann eine Abbildung in unterschiedliche Ebenen realisiert werden.

Anstelle eines ersten Arrays mit ersten Linsen können mehrere in Ausbreitungsrichtung des Lichts hintereinander angeordnete erste Arrays mit jeweils ersten Linsen vorgesehen sein. Beispielsweise können durch die Hintereinander-Anordnung zweier oder mehrerer erster Linsen zweier oder mehrerer erster Arrays Abbildungsfehler korrigiert werden.

Weiterhin kann vorgesehen sein, dass die Separiermittel mindestens ein zweites Array von zweiten Linsen umfassen, das in Ausbreitungsrichtung des Lichtes zwischen dem mindestens einen ersten Array und der auszuleuchtenden Fläche angeordnet ist, wobei die zweiten Linsen vorzugsweise sämtlich die gleiche Brennweite aufweisen.

Alternativ besteht die Möglichkeit, dass zumindest eine der zweiten Linsen eine von den Brennweiten der anderen zweiten Linsen unterschiedliche Brennweite aufweist. Dadurch kann eine Abbildung in unterschiedliche Ebenen realisiert werden.

Anstelle eines zweiten Arrays mit zweiten Linsen können mehrere in Ausbreitungsrichtung des Lichts hintereinander angeordnete zweite Arrays mit jeweils zweiten Linsen vorgesehen sein.

Insbesondere kann dabei vorgesehen sein, dass der Abstand zwischen dem mindestens einen ersten Array und dem mindestens einen zweiten Array in Ausbreitungsrichtung des Lichtes der Summe der Brennweite der ersten Linsen und der Brennweite der zweiten Linsen entspricht. Dadurch ergibt sich eine Teleskopanordnung, wobei über das Verhältnis der Brennweiten der ersten und der zweiten Linsen die Größe der Teilstrahlen zumindest hinsichtlich der ersten Richtung beeinflusst werden kann. Es besteht die Möglichkeit, dass einerseits die ersten Linsen und die zweiten Linsen eine positive Brechkraft beziehungsweise Brennweite aufweisen, so dass sich ein Keplersches Teleskop ergibt. Es besteht aber durchaus auch die Möglichkeit, dass die Brechkraft beziehungsweise Brennweite der ersten oder der zweiten Linsen negativ ist, so dass sich ein Galilei-Teleskop ergibt, bei dem der Abstand zwischen dem ersten und dem zweiten Array entsprechend kürzer ist.

Es besteht die Möglichkeit, dass sämtliche Aperturen der ersten Linsen gleich sind. Alternativ dazu besteht die Möglichkeit, dass zumindest eine der Aperturen der ersten Linsen verschieden von den anderen Aperturen der ersten Linsen ist.

Es besteht die Möglichkeit, dass sämtliche Aperturen der zweiten Linsen gleich sind. Alternativ dazu besteht die Möglichkeit, dass zumindest eine der Aperturen der zweiten Linsen verschieden von den anderen Aperturen der zweiten Linsen ist.

Durch unterschiedlich große Aperturen kann erreicht werden, dass einzelne der Teilstrahlen zumindest in der ersten Richtung größer sind als andere Teilstrahlen. Dadurch kann beispielsweise eine Maske mit unterschiedlich großen Öffnungen oder transparenten Abschnitten effektiv ausgeleuchtet werden.

Es kann vorgesehen sein, dass die Separiermittel mindestens ein drittes Array von dritten Linsen umfassen, das das Licht zumindest hinsichtlich einer zweiten Richtung, die zu der ersten Richtung senkrecht ist, in separate Teilstrahlen aufteilen kann, wobei die dritten Linsen vorzugsweise sämtlich die gleiche Brennweite aufweisen.

Alternativ besteht die Möglichkeit, dass zumindest eine der dritten Linsen eine von den Brennweiten der anderen dritten Linsen unterschiedliche Brennweite aufweist. Dadurch kann eine Abbildung in unterschiedliche Ebenen realisiert werden.

Anstelle eines dritten Arrays mit dritten Linsen können mehrere in Ausbreitungsrichtung des Lichts hintereinander angeordnete dritte Arrays mit jeweils dritten Linsen vorgesehen sein.

Weiterhin kann vorgesehen sein, dass die Separiermittel mindestens ein viertes Array von vierten Linsen umfassen, das in Ausbreitungsrichtung des Lichtes zwischen dem mindestens einen dritten Array und der auszuleuchtenden Fläche angeordnet ist, wobei die vierten Linsen vorzugsweise sämtlich die gleiche Brennweite aufweisen.

Alternativ besteht die Möglichkeit, dass zumindest eine der vierten Linsen eine von den Brennweiten der anderen vierten Linsen unterschiedliche Brennweite aufweist. Dadurch kann eine Abbildung in unterschiedliche Ebenen realisiert werden.

Anstelle eines vierten Arrays mit vierten Linsen können mehrere in Ausbreitungsrichtung des Lichts hintereinander angeordnete vierte Arrays mit jeweils vierten Linsen vorgesehen sein.

Insbesondere kann dabei vorgesehen sein, dass der Abstand zwischen dem mindestens einen dritten Array und dem mindestens einen vierten Array in Ausbreitungsrichtung des Lichtes der Summe der Brennweite der dritten Linsen und der Brennweite der vierten Linsen entspricht. Auch dadurch ergibt sich eine Teleskopanordnung, wobei über das Verhältnis der Brennweiten der ersten und der zweiten Linsen die Größe der Teilstrahlen zumindest hinsichtlich der zweiten Richtung beeinflusst werden kann. Es besteht die Möglichkeit, dass einerseits die ersten Linsen und die zweiten Linsen eine positive Brechkraft beziehungsweise Brennweite aufweisen, so dass sich ein Keplersches Teleskop ergibt. Es besteht aber durchaus auch die Möglichkeit, dass die Brechkraft beziehungsweise Brennweite der ersten oder der zweiten Linsen negativ ist, so dass sich ein Galilei-Teleskop ergibt, bei dem der Abstand zwischen dem ersten und dem zweiten Array entsprechend kürzer ist.

Es besteht die Möglichkeit, dass sämtliche Aperturen der dritten Linsen gleich sind. Alternativ dazu besteht die Möglichkeit, dass zumindest eine der Aperturen der dritten Linsen verschieden von den anderen Aperturen der dritten Linsen ist.

Es besteht die Möglichkeit, dass sämtliche Aperturen der vierten Linsen gleich sind. Alternativ dazu besteht die Möglichkeit, dass zumindest eine der Aperturen der vierten Linsen verschieden von den anderen Aperturen der vierten Linsen ist.

Auch bei den dritten und vierten Linsen kann durch unterschiedlich große Aperturen erreicht werden, dass einzelne der Teilstrahlen zumindest in der zweiten Richtung größer sind als andere Teilstrahlen. Dadurch kann beispielsweise eine Maske mit unterschiedlich großen Öffnungen oder transparenten Abschnitten effektiv ausgeleuchtet werden.

Es besteht die Möglichkeit, dass die ersten Linsen und/oder die zweiten Linsen und/oder die dritten Linsen und/oder die vierten Linsen als Zylinderlinsen ausgebildet sind, wobei sich insbesondere die Zylinderachsen der ersten und der zweiten Linsen in der zweiten Richtung und die Zylinderachsen der dritten und der vierten Linsen in der ersten Richtung erstrecken können. Derartige Zylinderlinsen können eine sphärische oder eine asphärische Gestaltung aufweisen.

Alternativ besteht die Möglichkeit, dass die Linsen eine im wesentlichen sphärische oder eine asphärische zirkularsymmetrische Gestalt aufweisen. Derartige Linsen können beispielsweise eine kreisförmige oder hexagonale Apertur abdecken.

Weiterhin besteht die Möglichkeit, dass die ersten Linsen und/oder die zweiten Linsen und/oder die dritten Linsen und/oder die vierten Linsen derart symmetrisch zur mittleren Ausbreitungsrichtung des für die Ausleuchtung zu verwendenden Lichts angeordnet sind, dass die ersten Linsen und/oder die zweiten Linsen und/oder die dritten Linsen und/oder die vierten Linsen die mittlere Ausbreitungsrichtung des Lichts nicht ändern.

Alternativ dazu besteht die Möglichkeit, dass die ersten Linsen und/oder die zweiten Linsen und/oder die dritten Linsen und/oder die vierten Linsen derart unsymmetrisch zur mittleren Ausbreitungsrichtung des für die Ausleuchtung zu verwendenden Lichts angeordnet sind, dass die ersten Linsen und/oder die zweiten Linsen und/oder die dritten Linsen und/oder die vierten Linsen die mittlere Ausbreitungsrichtung des Lichts ändern. Dadurch können alle oder einige der Teilstrahlen abgelenkt werden, so dass auch unregelmäßig verteilte Öffnungen oder transparente Abschnitte der Maske gezielt ausgeleuchtet werden können.

Anspruch 15 sieht vor, dass Vorrichtung zur Beaufschlagung eines Arbeitsbereichs mit Licht eine erfindungsgemäße Vorrichtung zur Ausleuchtung einer Fläche und eine Maske umfasst, die eine Mehrzahl von Öffnungen oder transparente Abschnitte für den Hindurchtritt des Lichtes in Richtung auf den Arbeitsbereich sowie zwischen den Öffnungen angeordnete opake Bereiche aufweist, wobei die Vorrichtung derart gestaltet ist, dass die von den Separiermitteln aufgeteilten separierten Teilstrahlen die auszuleuchtende Fläche derart beabstandet zueinander ausleuchten können, dass mindestens eine, insbesondere jede, der Öffnungen oder mindestens einer, insbesondere jeder, der transparenten Abschnitte vollständig ausgeleuchtet wird, andererseits aber die zwischen den Öffnungen oder transparenten Abschnitten angeordneten opaken Bereiche der Maske zumindest teilweise nicht ausgeleuchtet werden. Dadurch wird weniger Licht von der Maske absorbiert, so dass diese nicht gekühlt werden muss und die Intensität der Lichtquelle reduziert werden kann.

Weitere Merkmale und Vorteile der vorliegenden Erfindung werden deutlich anhand der nachfolgenden Beschreibung bevorzugter Ausführungsbeispiele unter Bezugnahme auf die beiliegenden Abbildungen. Darin zeigen
- Fig. 1a: eine Draufsicht auf eine erste Ausführungsform einer erfindungsgemäßen Vorrichtung;
- Fig. 1b: eine Seitenansicht der Vorrichtung gemäß Fig. 1a;
- Fig. 2a: eine Draufsicht auf Separiermittel und Maske einer zweiten Ausführungsform einer erfindungsgemäßen Vorrichtung;
- Fig. 2b: eine Seitenansicht der Separiermittel und der Maske der Vorrichtung gemäß Fig. 2a;
- Fig. 3: eine schematische Vorderansicht einer mit einer erfindungsgemäßen Vorrichtung ausgeleuchteten Maske;
- Fig. 4: eine schematische Vorderansicht einer weiteren mit einer erfindungsgemäßen Vorrichtung ausgeleuchteten Maske;
- Fig. 5a: eine Draufsicht auf Separiermittel und Maske einer dritten Ausführungsform einer erfindungsgemäßen Vorrichtung;
- Fig. 5b: eine Seitenansicht der Separiermittel und der Maske der Vorrichtung gemäß Fig. 5a.

In den Figuren sind zur besseren Orientierung kartesische Koordinatensysteme eingezeichnet.

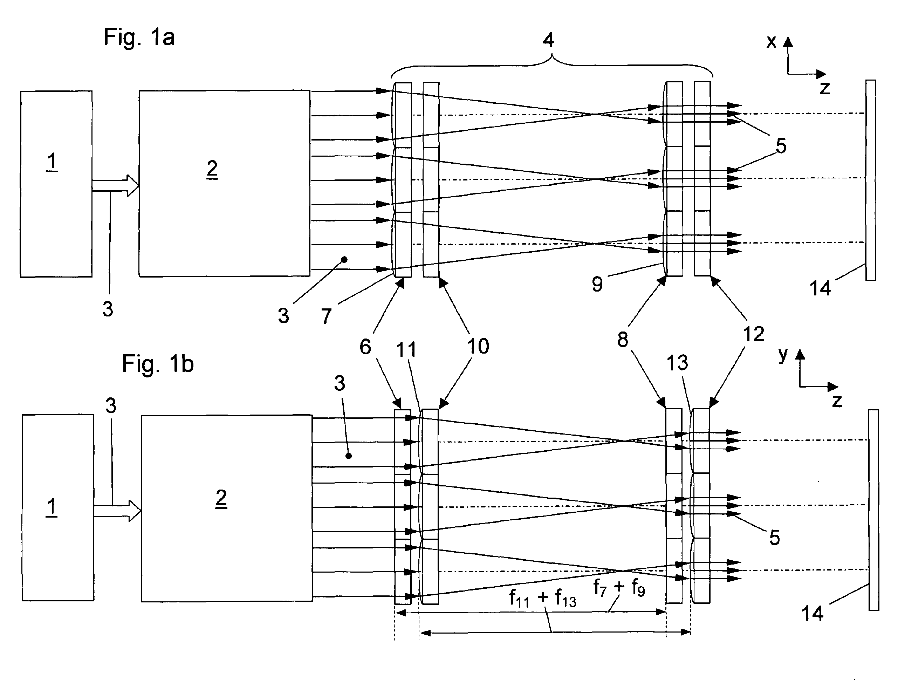

In Fig. 1a und Fig. 1b sind schematisch eine Lichtquelle 1 und Optikmittel 2 dargestellt. Die Lichtquelle 1 kann ein geeigneter Laser sein, wie beispielsweise ein Laserdiodenbarren oder ein Excimer-Laser oder ein Nd:YAG-Laser. Die Optikmittel 2 können nicht im Detail abgebildete Kollimiermittel und Homogenisatormittel umfassen, um das von der Lichtquelle 1 ausgehende Licht 3 zu kollimieren und zu homogenisieren.

Die Vorrichtung umfasst weiterhin Separiermittel 4, die das Licht 3 in einzelne voneinander separierte Teilstrahlen 5a, 5b aufteilen können.

Die Separiermittel umfassen ein erstes Array 6 von ersten als Zylinderlinsen ausgebildeten Linsen 7 und ein zweites Array 8 von zweiten als Zylinderlinsen ausgebildeten Linsen 9, die beide das Licht hinsichtlich der X-Richtung beeinflussen (siehe Fig. 1a). Dazu sind die Zylinderachsen der ersten und der zweiten Linsen 7, 9 in Y-Richtung ausgerichtet. Sowohl das erste Array 6, als auch das zweite Array 8 sind jeweils auf der Eintrittsfläche eines separaten Substrats angeordnet.

Die Aperturen sämtlicher erster Linsen 7 zumindest in X-Richtung sind gleich. Weiterhin sind auch die Aperturen sämtlicher zweiter Linsen 9 zumindest in X-Richtung gleich. Zusätzlich sind sowohl sämtliche der ersten Linsen 7, als auch sämtliche der zweiten Linsen 9 derart symmetrisch zur mittleren Ausbreitungsrichtung Z des Lichtes 3 ausgerichtet, das die mittlere Ausbreitungsrichtung Z des Lichtes 3 bei dem Hindurchtritt durch die ersten und/oder die zweiten Linsen 7, 9 keine Ablenkung erfährt. Weiterhin ist jeweils eine der ersten Linsen 7 in Z-Richtung genau einer der zweiten Linsen 9 gegenüberliegend angeordnet, so dass deren optische Achsen zusammenfallen.

Sämtliche erste Linsen 7 weisen die gleiche Brennweite f₇ auf. Weiterhin weisen auch sämtliche zweite Linsen 9 die gleiche Brennweite f₉ auf. Der Abstand des ersten Arrays 6 zu dem zweiten Array 8 entspricht der Summe f₇ + f₉ der Brennweiten f₇, f₉ der ersten und der zweiten Linsen 7, 9 (siehe Fig. 1b). Das erste und das zweite Array 6, 8 bilden somit eine Teleskopanordnung. Dabei sind die Brennweiten f₇ der ersten Linsen 7 größer, beispielsweise etwa dreimal so groß wie die Brennweiten f₉ der zweiten Linsen 9. Daher wird das homogene Licht 3 durch das aus dem ersten Array 6 und dem zweiten Array 8 bestehende Teleskop hinsichtlich der X-Richtung in zueinander separierte Teilstrahlen 5 aufgespalten.

Die Separiermittel umfassen weiterhin ein drittes Array 10 von dritten als Zylinderlinsen ausgebildeten Linsen 11 und ein viertes Array 12 von vierten als Zylinderlinsen ausgebildeten Linsen 13, die beide das Licht hinsichtlich der Y-Richtung beeinflussen (siehe Fig. 1b). Dazu sind die Zylinderachsen der dritten und der vierten Linsen 11, 13 in X-Richtung ausgerichtet. Sowohl das dritte Array 10, als auch das vierte Array 12 sind jeweils auf der Eintrittsfläche eines separaten Substrats angeordnet.

Im abgebildeten Ausführungsbeispiel ist das dritte Array 10 zwischen dem ersten Array 6 und dem zweiten Array 8 angeordnet. Alternativ kann es auch in Ausbreitungsrichtung des Lichts 3 vor dem ersten Array 6 oder hinter dem zweiten Array 8 angeordnet sein. Das vierte Array 12 ist im abgebildeten Ausführungsbeispiel in Ausbreitungsrichtung des Lichts 3 hinter dem zweiten Array 8 angeordnet. Alternativ kann es auch zwischen dem ersten Array 6 und dem zweiten Array 8 angeordnet sein.

Die Aperturen sämtlicher dritter Linsen 11 zumindest in Y-Richtung sind gleich. Weiterhin sind auch die Aperturen sämtlicher vierter Linsen 13 zumindest in Y-Richtung gleich. Zusätzlich sind sowohl sämtliche der dritten Linsen 11, als auch sämtliche der vierten Linsen 13 derart symmetrisch zur mittleren Ausbreitungsrichtung Z des Lichtes 3 ausgerichtet, das die mittlere Ausbreitungsrichtung Z des Lichtes 3 bei dem Hindurchtritt durch die dritten und/oder die vierten Linsen 11, 13 keine Ablenkung erfährt. Weiterhin ist jeweils eine der dritten Linsen 11 in Z-Richtung genau einer der vierten Linsen 13 gegenüberliegend angeordnet, so dass deren optische Achsen zusammenfallen.

Sämtliche dritte Linsen 11 weisen die gleiche Brennweite f₁₁ auf. Weiterhin weisen auch sämtliche vierte Linsen 13 die gleiche Brennweite f₁₃ auf. Der Abstand des dritten Arrays 10 zu dem vierten Array 12 entspricht der Summe f₁₁ + f₁₃ der Brennweiten f₁₁, f₁₃ der dritten und der vierten Linsen 11, 13 (siehe Fig. 1b). Das dritte und das vierte Array 10, 12 bilden somit ebenfalls eine Teleskopanordnung. Dabei sind die Brennweiten f₁₁ der dritten Linsen 11 größer, beispielsweise etwa dreimal so groß wie die Brennweiten f₁₃ der vierten Linsen 13. Daher wird das homogene Licht 3 durch das aus dem dritten Array 10 und dem vierten Array 12 bestehende Teleskop hinsichtlich der Y-Richtung in zueinander separierte Teilstrahlen 5 aufgespalten.

Weiterhin kann vorgesehen sein, das die Brennweiten f₇ der ersten Linsen 7 den Brennweiten f₁₁ der dritten Linsen 11 entsprechen. Zusätzlich können die Brennweiten f₉ der zweiten Linsen 9 den Brennweiten f₁₃ der vierten Linsen 13 entsprechen.

Die in Fig. 1a und Fig. 1b abgebildeten Arrays 6, 8, 10, 12 sind nur beispielhaft dargestellt und können eine deutlich größere Anzahl von Linsen 7, 9, 11, 13 aufweisen.

Die aus den Separiermitteln 4 austretenden Teilstrahlen 5 treffen auf eine Maske 14, die eine Mehrzahl von Öffnungen 15 oder transparenter Abschnitte für den Hindurchtritt des Lichtes aufweist.

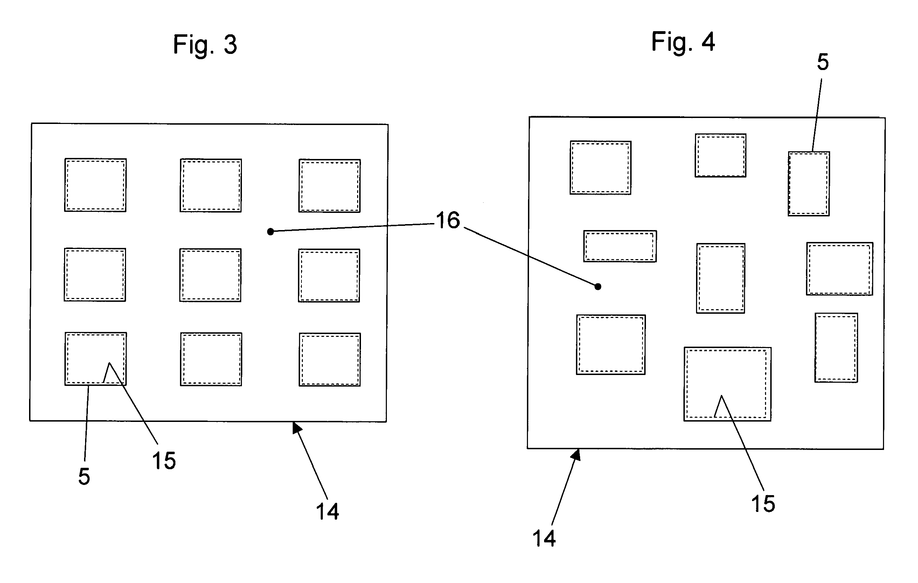

Aus Fig. 3 ist ersichtlich, dass die Teilstrahlen 5 (in Fig. 3 dargestellt als durchgezogene Linien) auf der Maske 14 jeweils auf eine der Öffnungen 15 (in Fig. 3 dargestellt als gestrichelte Linien) auftreffen und dabei eine Querschnittsfläche aufweisen, die nur unwesentlich größer als die lichte Weite der jeweiligen Öffnung 15 ist. Dadurch wird gewährleistet, dass einerseits jede der Öffnungen 15 vollständig ausgeleuchtet wird, andererseits aber nur sehr wenig Licht von den zwischen den Öffnungen 15 angeordneten opaken Bereichen 16 der Maske 14 absorbiert wird.

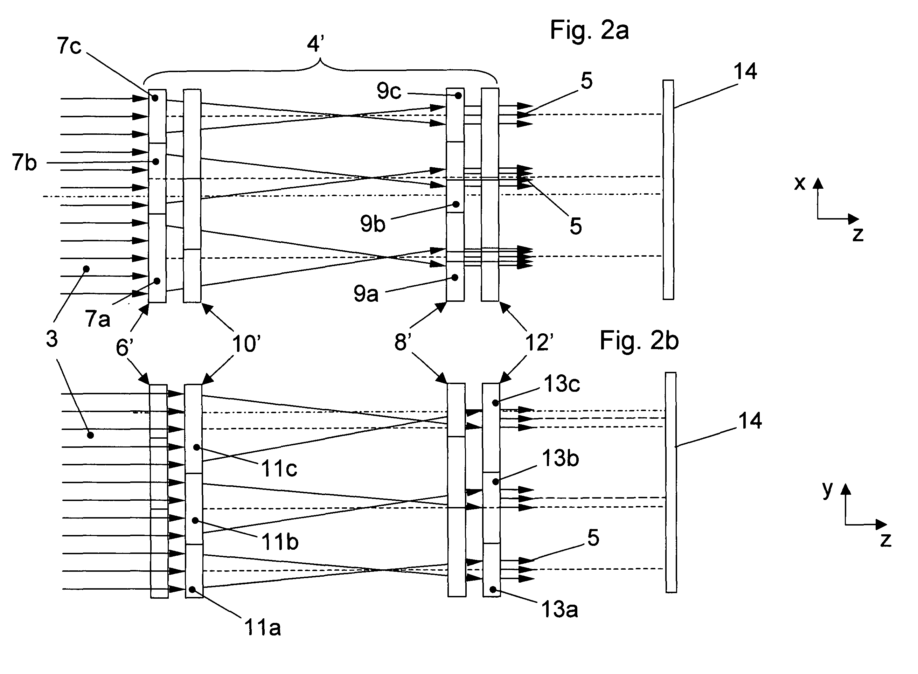

Bei der in Fig. 2a und Fig. 2b abgebildeten Ausführungsform sind gleiche Teile mit gleichen Bezugszeichen versehen wie in Fig. 1a und Fig. 1 b.

Die in Fig. 2a und Fig. 2b abgebildete Ausführungsform umfasst ebenfalls Separiermittel 4', die vier Arrays 6', 8', 10', 12' von Linsen 7a, 7b, 7c; 9a, 9b, 9c; 11 a, 11 b, 11 c; 13a, 13b, 13c aufweisen. Die Linsen 7a, 7b, 7c; 9a, 9b, 9c; 11a, 11b, 11c; 13a, 13b, 13c sind ebenfalls als Zylinderlinsen ausgebildet und weisen eine der Vorrichtung gemäß Fig. 1a und Fig. 1b entsprechende Ausrichtung auf. Weiterhin entsprechen auch die Brennweiten der Linsen 7a, 7b, 7c; 9a, 9b, 9c; 11 a, 11 b, 11 c; 13a, 13b, 13c denjenigen der Linsen 7, 9, 11, 13 der Vorrichtung gemäß Fig. 1a und Fig. 1b.

Allerdings weisen die Linsen 7a, 7b, 7c; 9a, 9b, 9c; 11a, 11b, 11c; 13a, 13b, 13c nicht alle die gleiche Apertur auf. Vielmehr sind die Aperturen der ersten Linsen 7a, 7b, 7c zumindest in X-Richtung ungleich zueinander. Weiterhin sind die Aperturen der zweiten Linsen 9a, 9b, 9c zumindest in X-Richtung ungleich zueinander. Weiterhin sind die Aperturen der dritten Linsen 11a, 11 b, 11c zumindest in Y-Richtung ungleich zueinander. Weiterhin sind die Aperturen der vierten Linsen 13a, 13b, 13c zumindest in Y-Richtung ungleich zueinander. Dadurch ergeben sich unterschiedlich große Querschnitte und/oder unterschiedliche Intensitäten der Teilstrahlen 5 auf der Maske 14.

Zusätzlich bestehen einige oder alle Linsen 7a, 7b, 7c; 9a, 9b, 9c; 11a, 11 b, 11c; 13a, 13b, 13c der Separiermittel 4' aus off-axis angeordneten Linsenausschnitten. Dadurch sind die Linsen 7a, 7b, 7c; 9a, 9b, 9c; 11a, 11b, 11c; 13a, 13b, 13c der Separiermittel 4' nicht symmetrisch zu der mittleren Ausbreitungsrichtung Z des Lichts 3 und lenken dieses somit ab. Dies ist beispielsweise in Fig. 2a bei den Linsen 7b und 9b sowie in Fig. 2b bei den Linsen 11 b, 11 c, 13 b und 13c gegeben.

Durch die unterschiedlichen Aperturen und die off-axis angeordneten Linsenausschnitte lassen sich mit den Separiermitteln 4' beliebige, insbesondere nicht überlappende Spotanordnungen auf der Maske 14 erzielen. Dies ist beispielhaft in Fig. 4 angedeutet.

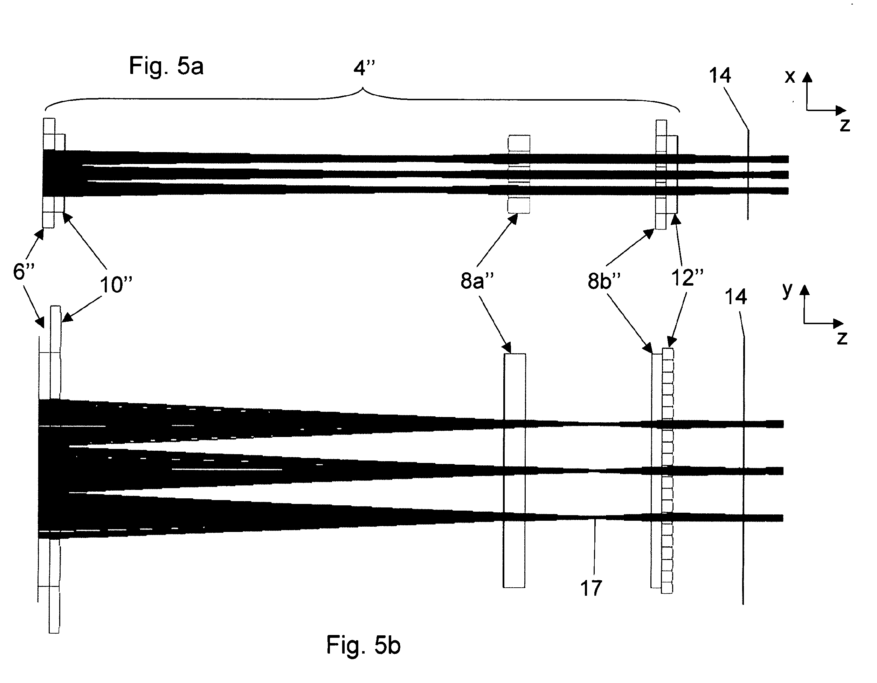

In Fig. 5a und Fig. 5b sind gleiche oder funktional gleiche Teile mit gleichen Bezugszeichen versehen wie in Fig. 1a, Fig. 1b, Fig. 2a und Fig. 2b.

Die in den Fig. 5a und Fig. 5b abgebildete Ausführungsform der Separiermittel 4" unterscheidet sich von der Ausführungsform gemäß Fig. 1a und Fig. 1b dadurch, dass die ersten beiden Arrays 6" und 10" auf einem Substrat zusammengefasst sind. Weiterhin ist das dritte Array in zwei zu einander beabstandete Teilarrays 8a" und 8b" aufgeteilt. Das zweite Teilarray 8b" ist mit dem vierten Array 12" auf einem Substrat zusammengefasst.

Durch die Aufteilung des dritten Arrays in zwei Teilarrays 8a" und 8b" wird erreicht, dass der mit dem Bezugszeichen 17 versehene Fokusbereich nicht innerhalb des dritten Arrays angeordnet ist, sondern zwischen den beiden Teilarrays 8a" und 8b".

## Patentansprüche

1. Vorrichtung zur Ausleuchtung einer Fläche, insbesondere zur Ausleuchtung einer Maske (14), beispielsweise für eine lithografische Anwendung, umfassend
- mindestens eine Lichtquelle (1) zur Erzeugung von Licht (3), das für die Ausleuchtung verwendet werden kann;
- Optikmittel (2) zur Formung des von der mindestens einen Lichtquelle (1) erzeugten Lichts (3);
**dadurch gekennzeichnet, dass** die Vorrichtung Separiermittel (4, 4', 4") umfasst, die das für die Ausleuchtung zu verwendende Licht (3) derart in mehrere von einander separierte Teilstrahlen (5) aufteilen können, dass diese die auszuleuchtende Fläche beabstandet zueinander ausleuchten können.

2. Vorrichtung nach Anspruch 1, **dadurch gekennzeichnet, dass** die Separiermittel mindestens ein erstes Array (6, 6', 6") von ersten Linsen (7; 7a, 7b, 7c) umfassen, das das Licht (3) zumindest hinsichtlich einer ersten Richtung (X) in separate Teilstrahlen (5) aufteilen kann, wobei die ersten Linsen (7; 7a, 7b, 7c) vorzugsweise sämtlich die gleiche Brennweite (f₇) aufweisen.

3. Vorrichtung nach Anspruch 2, **dadurch gekennzeichnet, dass** die Separiermittel (4, 4', 4") mindestens ein zweites Array (8, 8', 8a", 8b") von zweiten Linsen (9; 9a, 9b, 9c) umfassen, das in Ausbreitungsrichtung (Z) des Lichtes (3) zwischen dem mindestens einen ersten Array (6, 6', 6") und der auszuleuchtenden Fläche angeordnet ist, wobei die zweiten Linsen (9; 9a, 9b, 9c) vorzugsweise sämtlich die gleiche Brennweite (f₉) aufweisen.

4. Vorrichtung nach Anspruch 3, **dadurch gekennzeichnet, dass** der Abstand zwischen dem mindestens einen ersten Array (6, 6', 6") und dem mindestens einen zweiten Array (8, 8', 8a", 8b") in Ausbreitungsrichtung (Z) des Lichtes (3) der Summe der Brennweite (f₇) der ersten Linsen (7; 7a, 7b, 7c) und der Brennweite (f₉) der zweiten Linsen (9; 9a, 9b, 9c) entspricht.

5. Vorrichtung nach einem der Ansprüche 2 bis 4, **dadurch gekennzeichnet, dass** sämtliche Aperturen der ersten Linsen (7) gleich sind oder dass zumindest eine der Aperturen der ersten Linsen (7a, 7b, 7c) verschieden von den anderen Aperturen der ersten Linsen (7a, 7b, 7c) ist.

6. Vorrichtung nach einem der Ansprüche 2 bis 5, **dadurch gekennzeichnet, dass** sämtliche Aperturen der zweiten Linsen (9) gleich sind oder dass zumindest eine der Aperturen der zweiten Linsen (9a, 9b, 9c) verschieden von den anderen Aperturen der zweiten Linsen (9a, 9b, 9c) ist.

7. Vorrichtung nach einem der Ansprüche 1 bis 6, **dadurch gekennzeichnet, dass** die Separiermittel (4, 4', 4") mindestens ein drittes Array (10, 10', 10") von dritten Linsen (11; 11a, 11b, 11 c) umfassen, das das Licht (3) zumindest hinsichtlich einer zweiten Richtung (Y), die zu der ersten Richtung (X) senkrecht ist, in separate Teilstrahlen (5) aufteilen kann, wobei die dritten (11; 11a, 11 b, 11 c) Linsen vorzugsweise sämtlich die gleiche Brennweite (f₁₁) aufweisen.

8. Vorrichtung nach Anspruch 7, **dadurch gekennzeichnet, dass** die Separiermittel (4, 4') mindestens ein viertes Array (12, 12', 12") von vierten Linsen (13; 13a, 13b, 13c) umfassen, das in Ausbreitungsrichtung (Z) des Lichtes (3) zwischen dem mindestens einen dritten Array (10, 10', 10") und der auszuleuchtenden Fläche angeordnet ist, wobei die vierten Linsen (13; 13a, 13b, 13c) vorzugsweise sämtlich die gleiche Brennweite (f₁₃) aufweisen.

9. Vorrichtung nach Anspruch 8, **dadurch gekennzeichnet, dass** der Abstand zwischen dem mindestens einen dritten Array (10, 10', 10") und dem mindestens einen vierten Array (12, 12', 12") in Ausbreitungsrichtung (Z) des Lichtes (3) der Summe der Brennweite (f₁₁) der dritten Linsen (11; 11a, 11b, 11c) und der Brennweite der vierten Linsen (13; 13a, 13b, 13c) entspricht.

10. Vorrichtung nach einem der Ansprüche 7 bis 9, **dadurch gekennzeichnet, dass** sämtliche Aperturen der dritten Linsen (11) gleich sind oder dass zumindest eine der Aperturen der dritten (11 a, 1 1 b, 11c) Linsen verschieden von den anderen Aperturen der dritten Linsen (11a, 11 b, 11 c) ist.

11. Vorrichtung nach einem der Ansprüche 8 bis 10, **dadurch gekennzeichnet, dass** sämtliche Aperturen der vierten Linsen (13) gleich sind oder dass zumindest eine der Aperturen der vierten Linsen (13a, 13b, 13c) verschieden von den anderen Aperturen der vierten Linsen (13a, 13b, 13c) ist.

12. Vorrichtung nach einem der Ansprüche 2 bis 11, **dadurch gekennzeichnet, dass** die ersten Linsen (7; 7a, 7b, 7c) und/oder die zweiten Linsen (9; 9a, 9b, 9c) und/oder die dritten Linsen (11; 11a, 11 b, 11c) und/oder die vierten Linsen (13; 13a, 13b, 13c) als Zylinderlinsen ausgebildet sind, wobei insbesondere die Zylinderachsen der ersten und der zweiten Linsen (7; 7a, 7b, 7c; 9; 9a, 9b, 9c) sich in der zweiten Richtung (Y) erstrecken und die Zylinderachsen der dritten und der vierten Linsen (11; 11a, 11b, 11c; 13; 13a, 13b, 13c) sich in der ersten Richtung (X) erstrecken.

13. Vorrichtung nach einem der Ansprüche 2 bis 12, **dadurch gekennzeichnet, dass** die ersten Linsen (7; 7a, 7b, 7c) und/oder die zweiten Linsen (9; 9a, 9b, 9c) und/oder die dritten Linsen (11; 11a, 11b, 11 c) und/oder die vierten Linsen (13; 13a, 13b, 13c) derart symmetrisch zur mittleren Ausbreitungsrichtung (Z) des für die Ausleuchtung zu verwendenden Lichts angeordnet sind, dass die ersten Linsen (7; 7a, 7b, 7c) und/oder die zweiten Linsen (9; 9a, 9b, 9c) und/oder die dritten Linsen (11; 11a, 11b, 11c) und/oder die vierten Linsen (13; 13a, 13b, 13c) die mittlere Ausbreitungsrichtung (Z) des Lichts (3) nicht ändern.

14. Vorrichtung nach einem der Ansprüche 2 bis 12, **dadurch gekennzeichnet, dass** die ersten Linsen (7; 7a, 7b, 7c) und/oder die zweiten Linsen (9; 9a, 9b, 9c) und/oder die dritten Linsen (11; 11a, 11b, 11c) und/oder die vierten Linsen (13; 13a, 13b, 13c) derart unsymmetrisch zur mittleren Ausbreitungsrichtung (Z) des für die Ausleuchtung zu verwendenden Lichts (3) angeordnet sind, dass die ersten Linsen (7; 7a, 7b, 7c) und/oder die zweiten Linsen (9; 9a, 9b, 9c) und/oder die dritten Linsen (11; 11a, 11 b, 11 c) und/oder die vierten Linsen (13; 13a, 13b, 13c) die mittlere Ausbreitungsrichtung (Z) des Lichts (3) ändern.

15. Vorrichtung zur Beaufschlagung eines Arbeitsbereichs mit Licht, beispielsweise für eine lithografische Anwendung, umfassend eine Vorrichtung zur Ausleuchtung einer Fläche nach einem der Ansprüche 1 bis 14 und eine Maske (14), die eine Mehrzahl von Öffnungen (15) oder transparente Abschnitte für den Hindurchtritt des Lichtes (3) in Richtung auf den Arbeitsbereich sowie zwischen den Öffnungen (15) angeordnete opake Bereiche (16) aufweist, wobei die Vorrichtung derart gestaltet ist, dass die von den Separiermitteln (4, 4', 4") aufgeteilten separierten Teilstrahlen (5) die auszuleuchtende Fläche derart beabstandet zueinander ausleuchten können, dass mindestens eine, insbesondere jede, der Öffnungen (15) oder mindestens einer, insbesondere jeder, der transparenten Abschnitte vollständig ausgeleuchtet wird, andererseits aber die zwischen den Öffnungen (15) oder transparenten Abschnitten angeordneten opaken Bereiche (16) der Maske (14) zumindest teilweise nicht ausgeleuchtet werden.
